(19) Europäisches Patentamt
European Patent Office
Office européen des brevets

(11) **EP 3 488 508 B1**

(12) **FASCICULE DE BREVET EUROPEEN**

(45) Date de publication et mention de la délivrance du brevet:
**21.04.2021 Bulletin 2021/16**

(21) Numéro de dépôt: **17748822.8**

(22) Date de dépôt: **10.07.2017**

(51) Int Cl.:
*H01S 5/40* (2006.01)    *B29C 49/68* (2006.01)
*B29C 49/64* (2006.01)    *B29C 49/06* (2006.01)
*H01S 5/024* (2006.01)    *H01S 5/42* (2006.01)
*H01S 5/022* (2021.01)    *H01S 5/02208* (2021.01)

(86) Numéro de dépôt international:
**PCT/FR2017/051881**

(87) Numéro de publication internationale:
**WO 2018/015637 (25.01.2018 Gazette 2018/04)**

(54) **MODULE D'EMETTEURS LASER A HAUTE DENSITE ENERGETIQUE**

LASER-EMITTER-MODUL MIT HOHER ENERGIEDICHTE

HIGH-ENERGY-DENSITY LASER-EMITTER MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.07.2016 FR 1656853**

(43) Date de publication de la demande:
**29.05.2019 Bulletin 2019/22**

(73) Titulaire: **Sidel Participations**
**76930 Octeville-sur-Mer (FR)**

(72) Inventeurs:
• **FEUILLOLEY, Guy**
  **76930 Octeville-sur-mer (FR)**
• **LAHOGUE, Yoann**
  **76930 Octeville-sur-mer (FR)**

(74) Mandataire: **Sidel Group**
**c/o Sidel Participations**
**Avenue de la Patrouille de France**
**76930 Octeville-sur-mer (FR)**

(56) Documents cités:
**EP-A1- 2 977 182    DE-A1-102005 061 334**
**US-B1- 8 783 893**

**Description**

L'invention concerne les modules d'émetteurs laser, notamment destinés à équiper des modules de chauffe intégrés à des unités de traitement thermique de préformes de récipients en matière plastique, telles que celle décrite par exemple dans la demande de brevet français FR 2 982 790 (Sidel) ou son équivalent américain US 2014/0305919.

Les récents progrès dans la fabrication des diodes laser, et en particulier des diodes laser à cavité verticale émettant par la surface (Vertical cavity surface emitting laser ou VCSEL) ont abouti à la réalisation de puces électroniques intégrant des matrices de diodes de puissance et de densité surfacique suffisamment importantes pour constituer une concurrence crédible aux technologies classiques à lampes halogène.

L'intégration de ces puces (ci-après dénommées puces laser) au sein de modules de chauffe mérite cependant d'être perfectionnée, afin d'obtenir effectivement les avantages que l'on attend de la technologie laser (parmi lesquels une meilleure précision de chauffe permettant de réaliser des profils thermiques jusqu'alors inimaginables en technologie halogène).

En particulier, si l'architecture illustrée sur la figure 11 du brevet américain US 8 783 893 (Princeton Optronics) apparaît prometteuse, elle ne correspond qu'à un modèle théorique qu'il est difficile de transposer tel quel dans un module de chauffe destiné à équiper une unité de traitement thermique susceptible de satisfaire des exigences de production de plusieurs dizaines de milliers d'articles (en l'occurrence des préformes) par heure. Paradoxalement, les profils de chauffe les plus difficiles à obtenir en technologie laser sont les profils homogènes (c'est-à-dire les profils nécessitant une répartition spatiale homogène de la puissance émise), en raison de la précision du rayonnement émis.

Le document DE10 2005 061334 décrit un four de chauffe de préformes comprenant un agencement de diodes luminescentes, composé d'un sous-ensemble de DEL actionnables toutes ensemble, dont la hauteur correspond à la hauteur minimale de préformes traitées par l'installation d'étirage-soufflage, alors que d'autres lignes de DEL situées au-dessus dudit sous-ensemble peuvent être actionnables individuellement, pour adapter le champ de rayonnement au traitement de préformes plus hautes. L'inventeur s'est rendu compte que le four décrit présente quelques inconvénients. En particulier, le sous-ensemble décrit s'étendant sur la majeure partie de la hauteur du four, semble un composant très cher. L'inventeur a détecté un besoin de baisser les couts sans dégrader l'homogénéité de la chauffe. L'inventeur a également détecté un autre besoin consistant à chauffer plus certaines lignes que d'autres, de façon sélectionnable par l'opérateur.

Un objectif est par conséquent de proposer une architecture d'émetteurs laser qui, intégrée à un module de chauffe, facilite l'obtention d'un profil de chauffe souhaité, et notamment un profil de chauffe homogène et ceci de façon économique.

Dans la suite de la description et dans les revendications, les termes "supérieur", "haut", "inférieur", "latéral", "frontal", "horizontal", "vertical", "juxtaposé", "superposé", "adjacent", "arrière", "interne", "externe", etc., et leurs déclinaisons ("verticalement", "horizontalement", ...) sont employés en référence à l'orientation qui a été faite sur les figures. Ils n'ont donc aucune valeur limitative. Ainsi, par exemple, deux éléments dits superposés en référence aux figures, qui sont donc des éléments alignés selon un plan vertical ou pratiquement vertical, peuvent devenir des éléments juxtaposés lorsque le dispositif qui les comporte subit une rotation de 90° autour d'un axe horizontal perpendiculaire au dit plan ; dans un tel cas, des faces latérales deviendraient les faces supérieure et inférieure et vice-versa. Similairement, si le dispositif subissait une rotation de 90° autour d'un axe horizontal parallèle audit plan, une face frontale pourrait devenir la face supérieure ou bien la face inférieure et ceci selon le sens de la rotation ; dans un tel cas, les faces latérales le resteraient, mais, selon le sens de rotation appliqué, c'est la face supérieure qui deviendrait la face frontale, la face inférieure devenant alors la face arrière ou vice-versa. On comprendra que d'autres possibilités existent selon que la rotation est différente de 90° et/ou que l'axe de rotation au lieu d'être perpendiculaire au dit plan en est parallèle ou orienté différemment.

A cet effet, il est proposé, en premier lieu, un module, comprenant un corps et une série d'émetteurs laser, chacun des émetteurs laser étant fixé au corps en étant superposés et comprenant :

- un support présentant une face frontale et délimité, de part et d'autre de sa face frontale, par une face latérale supérieure et une face latérale inférieure opposées ;
- des puces laser montées sur la face frontale du support,
- au moins une alimentation en courant électrique des puces laser; module dans lequel, pour au moins deux émetteurs laser fixés au corps en étant superposés :
- les puces laser sont arrangées en au moins deux rangées de puces laser, y compris :

    ○ une rangée supérieure ayant un bord externe tourné vers la face latérale supérieure du support et un bord interne opposé,
    ○ une rangée inférieure ayant un bord externe tourné vers la face latérale inférieure du support et un bord interne opposé ; et

- la distance E1 entre les bords internes de deux rangées parallèles et adjacentes de puces est supérieure ou égale à la somme de la distance E3 du bord externe de la rangée supérieure à la face latérale supérieure et de la distance E4 du bord externe de la rangée inférieure à la face latérale inférieure.

Grâce à cette architecture, il est possible, en superposant correctement deux émetteurs, d'obtenir une répartition spatiale uniforme des rangées, et donc un rayonnement homogène des puces.

En effet, l'inventeur s'est en outre rendu compte que l'augmentation de la densité d'implantation de puces laser était limitée par la tension d'alimentation électrique des puces laser. Lorsque des rangées de puces émettrices de lumière sont côte à côte, la tension d'alimentation électrique peut être élevée et provoquer des arcs électriques et ainsi détruire les rangées de puces. Cela impose que les conducteurs d'alimentation électrique des puces laser, ou les puces laser elles-mêmes ne soient pas trop proches les unes des autres. Dans le module de chauffe de l'invention, le même support tient ensemble au moins deux rangées de puces laser présentant un espace « interne » entre ces deux rangées adjacentes d'éléments électriquement conducteurs. Cet « espace interne » est de largeur supérieure ou égale à l'espace définie par les bords du support. Cet espace entre les puces laser et les bords du support garanti également un espace entre les puces laser conductrices appartenant à deux émetteurs laser voisins. Ainsi, grâce à l'invention, on peut augmenter la densité d'implantation des puces laser en réduisant de manière harmonieuse, à la fois « l'espace interne » à un émetteur laser et l'espace entre deux puces laser appartenant à deux émetteurs laser voisins, sans provoquer d'endroits plus susceptibles que d'autres de voir se former un arc électrique. Autrement dit, la disposition particulière des rangées de puces laser sur leur support contribue de manière fiable à améliorer la densification de la chauffe.

L'inventeur s'est encore rendu compte que l'homogénéité de la chauffe générée par une série de puces laser dépendait notamment de l'effet de chauffe dans la zone entre deux puces laser voisines. Si des puces laser voisines l'une de l'autre sont trop éloignées, l'effet de chauffe peut être insuffisant dans la zone entre ces deux puces laser voisines. La bonne distance entre deux puces laser dépend en particulier du type de puce laser, et si les faisceaux émis par chaque puces laser sont plus ou moins divergents. Par exemple des puces laser de type VCSEL émettent un faisceau légèrement divergeant. Dans le module de chauffe de l'invention, « l'espace interne » est de largeur supérieure ou égale à l'espace définie par les bords du support. Cela permet d'harmoniser le chevauchement d'effets de chauffe issus de deux rangées de puces laser d'un même émetteur laser et le chevauchement d'effets de chauffe issus de rangée de puces laser appartenant à deux émetteurs laser voisins. Autrement dit, la disposition particulière des rangées de puces laser sur leur support contribue à améliorer l'homogénéité de la chauffe.

En outre, l'inventeur s'est rendu compte que pouvoir conserver la distance interne entre puces, pour des puces laser appartenant à des « émetteur laser » différents permet d'avoir des émetteurs laser plus petit. Le support sur lequel sont disposées les puces laser est de beaucoup plus petite dimension que la paroi du four à équiper. On obtient une plus grande flexibilité d'utilisation. On peut à la demande disposer d'une chauffe homogène ou bien d'une chauffe plus importante sur certaines lignes que sur d'autres, en faisant chauffer plus certains émetteurs laser que d'autres, au choix de l'opérateur.

D'autre part, un module de chauffe avec des émetteurs laser de plus petite dimension s'accompagne d'un nombre d'émetteurs laser installés sur un four beaucoup plus important. L'industrialisation peut porter sur l'émetteur laser multi-rangées de petite dimension. Cela ouvre la voie à une fiabilité améliorée et/ou une baisse de cout.

Enfin, l'inventeur c'est également rendu compte que le fait d'avoir un assemblage ayant notamment trois niveaux que sont : la puce laser, le support multi-rangée et le corps de module, permet d'avoir une évacuation de calories plus efficace au niveau du support de petite dimension. Dans une variante avantageuse mais non obligatoire, ce support recevant plusieurs rangées de plus laser peut-être un « micro cooler » alors que le corps du module peut être un radiateur plus traditionnel.

Diverses caractéristiques supplémentaires peuvent être prévues, seules ou en combinaison :

- chaque puce laser est une puce composée d'une ou de plusieurs cavités LASER à émission de surface, par exemple non limitatif, une puce de type VCSEL (vertical-cavity surface-emitting laser), ou VECSEL (vertical-external-cavity surface-emitting-laser) ou SE-DFB (surface emitting distributed feedback laser)
- chaque rangée de puces est reliée à une alimentation en courant électrique dédiée munie d'une paire de bornes électriques de signes opposés ;
- chaque rangée comprend deux brins parallèles de puces, à savoir un brin externe relié à une borne électrique, et un brin interne relié, par une extrémité, au brin externe et, par une extrémité opposée, à la borne électrique de signe opposé ;
- la distance E1 est comprise entre 0,2 mm et 1 mm ;
- la distance E3 et la distance E4 sont toutes deux comprises entre 0,1 mm et 0,5 mm ;
- les distances E3 et E4 sont égales ;
- les puces sont conçues pour émettre dans le domaine infrarouge,
- certain, ou la majeure partie, ou la totalité des émetteurs laser d'un même module sont identiques
- les émetteurs laser superposé d'un même module forment une paroi (32) émettrice.

Il est proposé, en deuxième lieu, un module de chauffe comprenant un corps et une série d'émetteurs laser tels que l'émetteur présenté ci-dessus, dont les puces sont conçues pour émettre dans le domaine infrarouge, lesquels émetteurs sont fixés sur le corps en étant superposés, la distance E2 entre le bord externe de la rangée supérieure d'un émetteur et le bord externe de la rangée inférieure d'un émetteur qui lui est superposé étant sensiblement égale à E1. Par "série d'émetteurs", il faut entendre ici "au moins deux émetteurs".

Autrement dit, il est proposé un module, comprenant un corps et une série d'émetteurs laser, chacun des émetteurs laser étant fixé au corps en étant superposés et comprenant:

- un support présentant une face frontale et délimité, de part et d'autre de sa face frontale, par une face latérale supérieure et une face latérale inférieure opposées ;
- des puces laser montées sur la face frontale du support,
- au moins une alimentation en courant électrique des puces laser; module pour lequel, pour au moins un premier émetteur laser et pour un deuxième émetteur laser superposé au premier émetteur laser :
- les puces laser sont arrangées en au moins deux rangées de puces laser, y compris :

    ◦ une rangée supérieure ayant un bord externe tourné vers la face latérale supérieure du support et un bord interne opposé,
    ◦ une rangée inférieure ayant un bord externe tourné vers la face latérale inférieure du support et un bord interne opposé ; et

- la distance E2 entre la rangée supérieure du premier émetteur laser et la rangée inférieure du deuxième émetteur laser est sensiblement égale à E1.

Dans ce module, peuvent également être prévues, seules ou en combinaison, les caractéristiques supplémentaires listées plus haut.

Il est proposé, en troisième lieu, une installation de chauffe de préformes en matière plastique, comprenant une série de modules de chauffe tels que celui présenté ci-dessus, lesquels modules sont juxtaposés. Par "série de modules", il faut entendre ici "au moins deux modules".

Par « puces laser », on entend une cavité laser ou bien une pluralité de cavités laser réalisées dans un même substrat, appelé « puce », par exemple en silicium ou en tout autre matériau adapté à l'émission laser. La ou les cavités laser peuvent être de type à émission par la tranche et/ou à émission verticale. Lorsqu'il y a une pluralité de cavités laser sur la même puce laser, ces cavités peuvent être disposées en lignes, ou en matrice, ou selon tout autre répartition, de préférence régulière et/ou identique d'une puce à l'autre.

D'autres objets et avantages de l'invention apparaîtront à la lumière de la description d'un mode de réalisation, faite ci-après en référence aux dessins annexés dans lesquels :

- la figure 1 est une vue en perspective d'un émetteur laser, avec en médaillons deux détails à plus grande échelle ;
- la figure 2 est une vue de face de l'émetteur de la figure 1, avec en médaillon un détail à plus grande échelle ;
- la figure 3 est une vue en coupe partielle de l'émetteur de la figure 2, selon le plan de coupe III-III, avec en médaillon un détail à plus grande échelle ;
- la figure 4 est une vue en plan montrant deux émetteurs superposés ;
- la figure 5 est une vue de détail à plus grande échelle des émetteurs de la figure 4, selon l'encart V ; trois détails supplémentaires sont illustrés dans trois médaillons superposés ;
- la figure 6 est une vue en perspective éclatée montrant, par l'avant, un module de chauffe équipé de plusieurs émetteurs laser superposés, tels qu'illustrés sur les figures 1, 2 et 4 ;
- la figure 7 est une vue en perspective montrant le module de chauffe assemblé ;
- la figure 8 est une vue en perspective montrant une unité de conditionnement thermique de préformes intégrant deux séries en vis-à-vis de modules de chauffe juxtaposés tels qu'illustrés sur la figure 7.

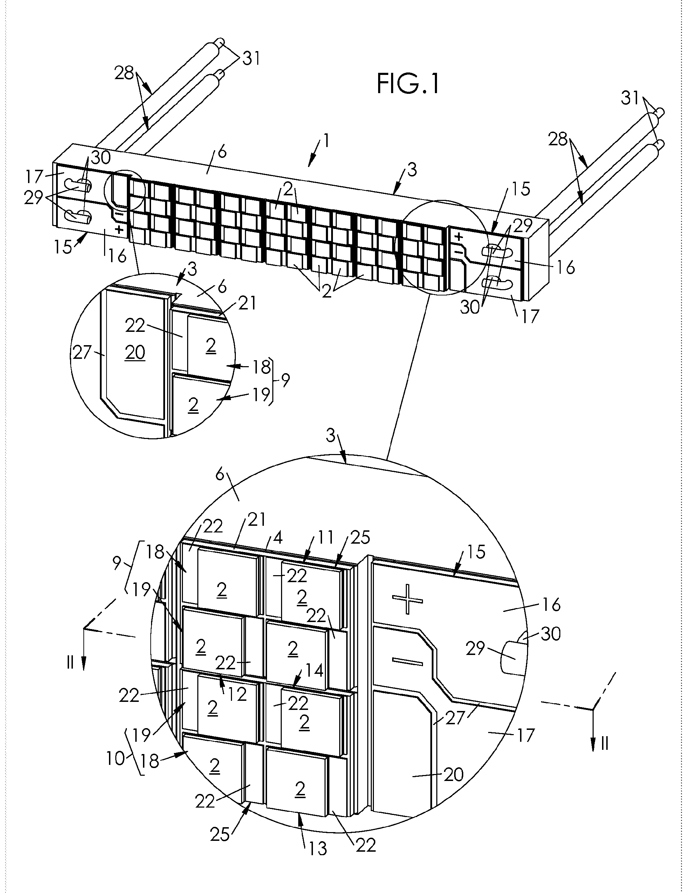

Sur la figure 1 est illustré un émetteur **1** laser comprenant une pluralité de puces **2** électroniques à semi-conducteur, intégrant chacune une multitude de diodes laser, de préférence de type VCSEL (acronyme de laser à cavité verticale émettant par la surface) organisées en matrice. Dans ce qui suit, on nomme indifféremment « puce » ou « puce laser » une telle puce. L'expression « puce VCSEL » désigne quant à elle une puce dont les diodes sont de type VCSEL.

Chaque puce **2** laser se présente sous forme d'une plaque formée d'un sandwich dont la surface est percée, au droit de chaque diode, d'une ouverture par laquelle celle-ci rayonne un faisceau laser. A l'échelle humaine, chaque puce **2** est petite, sa surface étant de l'ordre de quelques mm$^2$. Selon un mode particulier de réalisation, chaque puce **2** présente un contour carré d'environ 2 mm de côté et une épaisseur de l'ordre de quelques dixièmes de mm. Les dimensions de chaque diode VCSEL étant cependant microscopiques (le diamètre de son ouverture étant de l'ordre de 5 à 10 $\mu$m), chaque puce **2** VCSEL est constituée de plusieurs milliers de diodes VCSEL, de l'ordre de 2200 pour une puce à contour carré de 2 mm de côté. Cette densité, fournie à titre d'exemple, est valable à la date du dépôt de la présente demande et peut être amenée à évoluer avec les progrès continus de la technologie VCSEL.

Dans une puce **2** laser ou VCSEL, toutes les diodes sont alimentées en courant par un même substrat conducteur. Les diodes sont donc montées en parallèle, le dysfonctionnement de l'une d'elles n'ayant pas de conséquence sur le fonctionnement des autres. C'est l'une des raisons pour lesquelles une puce **2** VCSEL est extrêmement fiable et durable, pourvu que l'on respecte certaines règles de câblage (le câblage des puces **2** est exposé ci-après).

Selon un mode préféré de réalisation, les diodes VCSEL émettent dans le domaine de l'infrarouge, c'est-à-dire que la longueur d'onde émise est supérieure ou égale à 750 μm environ.

L'émetteur 1 comprend un support **3**, de préférence réalisé dans un matériau ayant une bonne conductibilité thermique (par ex. en cuivre). Ce support **3**, de forme grossièrement prismatique, présente une face **4** frontale de contour sensiblement rectangulaire, et une face **5** arrière opposée à la face **4** frontale. Le support **3** est délimité, de part et d'autre de sa face **4** frontale, par une face **6** latérale supérieure et une face **7** latérale inférieure opposées, planes.

Les dimensions du support **3** peuvent varier selon le nombre de puces **2** laser que l'on souhaite y monter. Pour des applications courantes (telles que la chauffe de préformes **8** de récipients, comme nous l'expliquerons ci-après), le support **3** présente une longueur comprise entre 50 et 100 mm, une largeur (c'est-à-dire la distance entre les faces **6**, **7** latérales) comprise entre 7 mm et 10 mm, et une épaisseur (c'est-à-dire la distance entre la face **4** frontale et la face **5** arrière) comprise entre 5 et 10 mm. Dans l'exemple illustré, la longueur du support **3** est de 65 mm environ ; sa largeur est de 8,5 mm environ, et son épaisseur de 7,5 mm environ.

L'émetteur **1** comprend au moins deux rangées **9**, **10** parallèles de puces **2** montées sur la face **4** frontale du support **3**. Plus précisément l'émetteur **1** comprend en particulier :

    ◦ une rangée **9** supérieure de puces **2**, qui présente un bord **11** externe tourné vers la face **6** latérale supérieure du support **3** et un bord **12** interne opposé,
    ◦ une rangée **10** inférieure de puces **2**, qui présente un bord **13** externe tourné vers la face **7** latérale inférieure du support **3** et un bord **14** interne opposé.

Des rangées supplémentaires de puces **2** laser peuvent être intercalées entre la rangée **9** supérieure et la rangée **10** inférieure. Cependant, dans l'exemple illustré, l'émetteur **1** comprend les seules rangées **9** supérieure et **10** inférieure, qui sont disposées de manière parallèle et adjacente.

L'émetteur **1** comprend en outre une alimentation **15** en courant électrique des puces **2**. Cette alimentation **15** inclut deux bornes **16**, **17** de signes électriques opposés, à savoir une anode **16**, qui porte par convention le signe +, et une cathode **17**, qui porte par convention le signe -. Dans la suite de la description, lorsqu'il ne sera pas important de faire la distinction, les références **16**, **17** seront associées au terme "borne(s)" ; lorsque la distinction sera nécessaire, la référence **16** sera utilisée pour l'anode et la référence **17** pour la cathode.

Selon un mode préféré de réalisation, chaque rangée **9**, **10** de puces **2** est reliée à une alimentation **15** dédiée. Dans l'exemple illustré, l'émetteur **1** comprend par conséquent deux alimentations **15** distinctes (mais similaires), à savoir une première alimentation **15** pour la rangée **9** supérieure, et une deuxième alimentation **15** pour la rangée **10** inférieure.

Par ailleurs, dans l'exemple illustré, chaque rangée **9**, **10** comprend deux brins **18**, **19** parallèles de puces **2**, à savoir un brin **18** externe relié à une borne électrique de l'alimentation **15** dédiée à cette rangée, et un brin **19** interne relié, d'une part, par une extrémité, au brin **18** externe et d'autre part, par une extrémité opposée, à la borne électrique de signe opposé.

Dans l'exemple illustré, le brin **18** externe est relié électriquement à l'anode **16**, et le brin **19** interne à la cathode **17**.

Dans chaque brin **18**, **19**, les puces **2** sont branchées en série, et le brin **19** interne est branché en série sur le brin **18** externe, de sorte que toutes les puces **2** de chaque rangée **9**, **10** sont branchées elles-mêmes en série. Les bornes **16**, **17** de chaque alimentation **15** peuvent ainsi être montées du même côté du support **3**, le branchement en série des brins **18**, **19** étant réalisé via une borne **20** retour montée sur le support **3** du côté opposé à l'alimentation **15**.

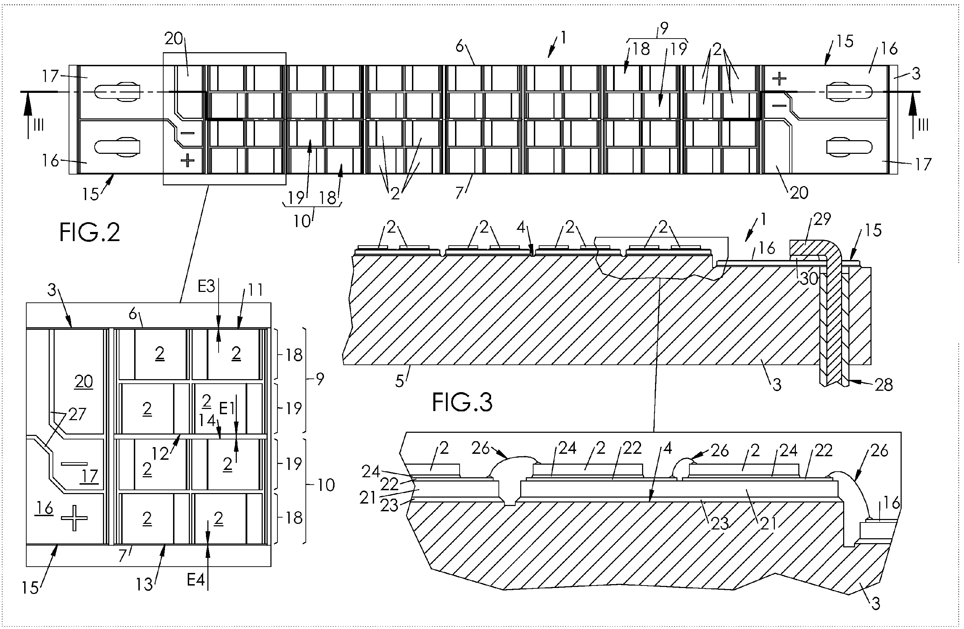

Selon un mode de réalisation illustré sur la figure 3, le montage des puces **2** laser sur le support **3** est réalisé via une structure sous-jacente qui comprend une embase **21** (résistive dans son épaisseur), avantageusement réalisée dans une céramique, par ex. en nitrure d'aluminium (AlN), et portant sur une face supérieure une couche **22** métallique (par ex. en aluminium) destinée à assurer la conduction du courant alimentant chaque puce **2**. L'embase **21** est fixée sur le support **3** au moyen d'une soudure **23**, par ex. du type étain-argent-cuivre (SnAgCu).

Chaque puce **2** laser est enfin fixée sur l'embase **21** en étant soudée sur la couche **22** métallique, par exemple au moyen d'une soudure **24** or- étain. Selon un mode de réalisation avantageux permettant une réalisation modulaire de chaque émetteur **1**, l'embase **21** est commune à quatre puces **2**, à savoir une paire de puces **2** destinées à être intégrées au brin **18** externe, et une paire de puces **2** destinées à être intégrées au brin **19** interne. Dans l'exemple illustré, les puces **2** du brin **18** externe sont décalées latéralement par rapport aux puces **2** du brin **19** interne.

Une couche **22** métallique est en revanche prévue pour chaque puce **2**, de sorte que chaque embase **21** porte quatre couches **22** métalliques séparées, entre lesquelles sont ménagés des interstices qui assurent l'isolation électrique mutuelle des couches **22** (en particulier les couches **22** des puces **2** du brin **18** externe et celles des puces **2** du brin **19** interne).

Il est ainsi possible de réaliser des sous-ensembles **25** modulaires préassemblés comprenant une embase **21** portant quatre couches **22** métalliques et quatre puces **2** laser, chacune soudée sur une couche **22** métallique. Chaque sous-ensemble **25** peut alors être monté sur le support **3** par soudure de l'embase **21** sur la face **4** frontale.

Après le montage des sous-ensembles **25**, le câblage électrique de chaque rangée **9**, **10** de puces **2** est réalisé au moyen d'un circuit électrique qui, comme illustré partiellement sur la figure 3, comprend une pluralité de bus **26** incluant chacun une série de fils métalliques reliant respectivement :

- l'anode **16** à la première puce **2** du brin **18** externe, chaque fil étant soudé d'une part sur l'anode **16**, d'autre part sur la puce **2** ;
- chaque couche **22** métallique à la puce **2** voisine du même brin **18** (ou **19**) ;
- la borne **20** retour à la couche **22** métallique de la dernière puce **2** du brin **18** externe,
- la borne **20** retour à la première puce **2** du brin **19** interne ;
- la dernière puce **2** du brin **19** interne à la cathode **17**, chaque fil étant soudé d'une part sur la puce **2**, d'autre part sur la cathode **17**.

Dans l'exemple illustré, l'alimentation **15** électrique de la rangée **9** supérieure est montée à une extrémité droite du support **3**, l'anode **16** étant placée au droit du brin **18** externe et la cathode **17** au droit du brin **19** interne. L'anode **16**, la cathode **17** et la borne **20** retour se présentent chacune sous forme d'une plaque métallique (par ex. en cuivre ou en aluminium). Comme on le voit notamment sur la figure 1, l'anode **16** et la cathode **17** de l'alimentation d'une première rangée (**9** ou **10**) et la borne **20** retour de la deuxième rangée (**10** ou, respectivement, **9**) sont imbriquées en étant séparées par des interstices **27** qui assurent leur isolation électrique mutuelle.

Comme on le voit bien sur les figures 1 et 3, l'anode **16** et la cathode **17** sont alimentées électriquement au moyen de conducteurs **28** gainés traversant le support **3** et ayant une extrémité **29** avant fixée à l'anode **16** (respectivement la cathode **17**) au moyen d'une soudure **30** conductrice, et une extrémité **31** arrière par laquelle le conducteur **28** est branché à un réseau électrique, éventuellement via un transformateur.

De la sorte, et en considérant le sens conventionnel de circulation du courant (de l'anode vers la cathode, les électrons circulant en sens inverse), le courant circule :

- d'abord dans un premier sens dans le brin **18** externe, depuis l'anode **16** jusqu'à la borne **20** retour (de droite à gauche dans le brin **18** externe de la rangée **9** supérieure, lorsque l'émetteur 1 est vu de face comme sur la figure 2) via les bus **26**,
- puis dans le sens opposé dans le brin **19** interne, depuis la borne **20** retour jusqu'à la cathode **17** (de gauche à droite dans le brin **19** interne de la rangée **9** supérieure, lorsque l'émetteur **1** est vu de face comme sur la figure 2) via les bus **26**.

Comme on le voit bien sur la figure 2, les puces **2** du brin **18** externe sont alignées ; il en va de même des puces **2** du brin **19** interne. Dans chaque rangée **9**, **10**, le bord **11** (respectivement **13**) externe est sensiblement confondu avec les bords alignés des puces **2** du brin **18** externe, et le bord **12** (respectivement **14**) interne est sensiblement confondu avec les bords alignés des puces **2** du brin **19** interne.

Les puces **2** produisent de la chaleur en rayonnant (en particulier si elles rayonnent dans le domaine l'infrarouge). Outre que cette chaleur est transmise pour partie au support **3**, ce qui tend à le dilater et peut endommager l'ensemble de l'émetteur 1 par fatigue thermique, elle peut affecter le bon fonctionnement des puces **2**. Il est donc préférable de réguler thermiquement l'émetteur **1** pour le maintenir dans une plage de température correspondant à l'optimum de fonctionnement des puces **2**.

A cet effet, le support **3** intègre un circuit fluidique (non représenté pour des raisons de clarté) dans lequel circule un fluide caloporteur (tel que de l'eau) dont la température et le débit sont réglés en fonction des calories à évacuer, c'est-à-dire de la puissance dissipée par les puces **2**.

Plusieurs émetteurs **1** identiques peuvent être superposés pour former une paroi **32** émettrice qui peut elle-même être intégrée à un dispositif **33** rayonnant, comme nous le verrons ci-après.

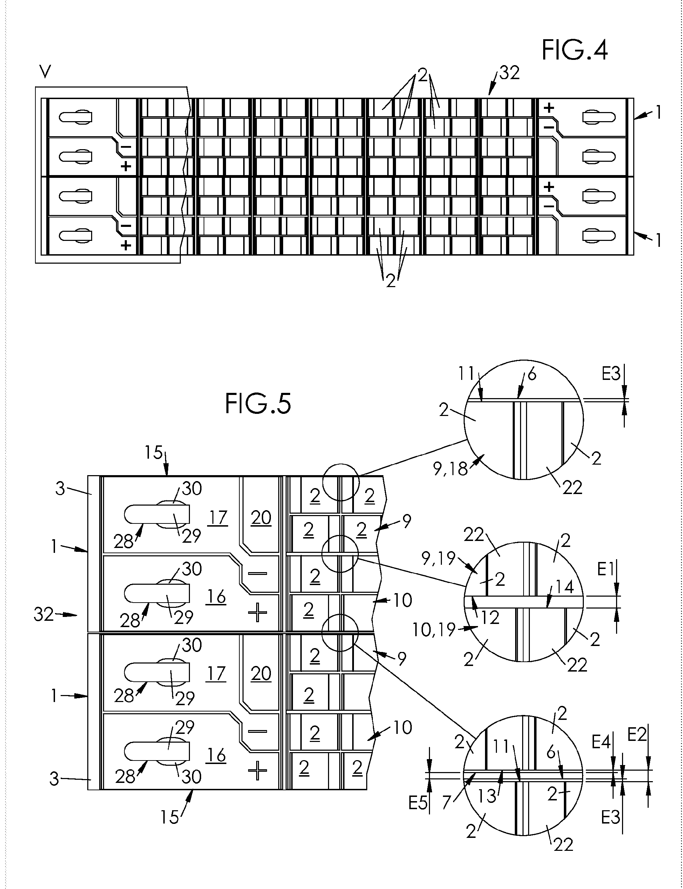

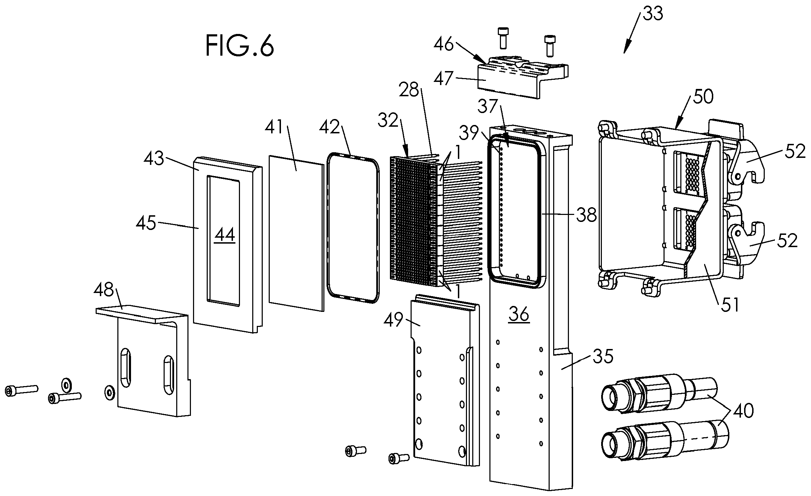

On a représenté sur les figures 4 et 5 une paroi **32** émettrice constituée de deux émetteurs **1** superposés. Sur la figure 6, on a représenté un dispositif **33** rayonnant comprenant une paroi **32** émettrice constituée d'une série d'émetteurs **1** superposés, en l'espèce au nombre de douze.

On note :

- E1 la distance entre les bords **12**, **14** internes de deux rangées **9**, **10** adjacentes (en l'espèce la rangée **9** supérieure et la rangée **10** inférieure) au sein du même émetteur **1** ;
- E2 la distance entre le bord **11** externe de la rangée **9** supérieure d'un émetteur **1** et le bord **13** externe de la rangée **10** inférieure d'un émetteur **1** qui lui est superposé au sein d'un dispositif **33** rayonnant ;
- E3 la distance du bord **11** externe de la rangée **9** supérieure à la face **6** latérale supérieure du support **3** (E3 peut être nulle, c'est-à-dire que la rangée **9** supérieure peut affleurer la face **6** latérale supérieure du support **3**) ;
- E4 la distance du bord **13** externe de la rangée **10** inférieure à la face **7** latérale inférieure du support **3** (E4 peut être nulle, c'est-à-dire que la rangée **10** inférieure peut affleurer la face **7** latérale inférieure du support **3**) ;
- E5 la distance entre la face **6** latérale supérieure d'un émetteur **1** et la face **7** latérale inférieure de l'émetteur **1** voisin.

Par définition, E2 est égale à la somme des distances E3, E4 et E5 :

$$E2 = E3 + E4 + E5$$

Les rangées **9**, **10** sont disposées sur chaque émetteur **1** de façon à permettre, en réglant correctement la distance E5, d'obtenir au sein de la paroi **32** émettrice une répartition spatiale uniforme des rangées **9**, **10** (ce qui permet d'obtenir un rayonnement homogène des puces **2**).

En d'autres termes :

$$E1 \cong E2$$

Il en résulte que :

$$E1 \cong E3 + E4 + E5$$

Les distances E1, E3 et E4, intrinsèques à l'émetteur, sont fixes. La distance E5 peut quant à elle être réglée par modification de l'écartement entre deux émetteurs **1** voisins.

Aussi, pour satisfaire cette équation, la disposition des rangées **9**, **10** sur le support **3** doit être telle que la distance E1 est supérieure ou égale à la somme des distances E3 et E4 :

$$E1 \geq E3 + E4$$

Les distances E3 et E4 peuvent d'ailleurs être égales (comme c'est le cas dans l'exemple illustré) :

$$E3 = E4$$

Dans ce cas :

$$E1 \geq 2 \cdot E3$$

Dans le cas particulier où E1 est égale à la somme des distances E3 et E4, alors, pour obtenir une répartition uniforme des rangées **9**, **10** au sein de la paroi **32** émettrice, les émetteurs **1** doivent être accolés.

En d'autres termes, si

$$E1 = E3 + E4$$

alors

$$E5 = 0$$

On fournit ci-après des gammes de valeurs possibles pour E1, E3 et E4 :

$$0,2 \text{ mm} \leq E1 \leq 1 \text{ mm}$$

$$0,1 \text{ mm} \leq E3 \leq 0,5 \text{ mm}$$

$$0,1 \text{ mm} \leq E4 \leq 0,5 \text{ mm}$$

Et, selon un mode particulier de réalisation :

$$E1 = 0,4 \text{ mm}$$

$$E3 = E4 = 0,1 \text{ mm}$$

$$E5 = 0,2 \text{ mm}$$

De sorte que :

$$E2 = E3 + E4 + E5 = 0,4 \text{ mm} = E1$$

On décrit à présent le dispositif **33** rayonnant illustré aux figures 6, 7 et 8. On suppose dans ce qui suit que les diodes VCSEL des puces **2** émettent dans le domaine de l'infrarouge, ce qui permet notamment de chauffer tout article soumis au rayonnement émis par les diodes. Le dispositif **33** rayonnant peut être conçu de manière modulaire pour être intégré au sein d'une installation **34** de conditionnement thermique, notamment de préformes **8** de récipients en matière plastique (tel que PET). Dans ce contexte, on nomme « module de chauffe » le dispositif **33** rayonnant et la référence **33** sera associée indifféremment au module de chauffe ou au dispositif rayonnant.

Le module **33** de chauffe comprend un corps **35** réalisé dans un matériau conducteur de la chaleur (par ex. en aluminium) et une série d'émetteurs **1** (dont les puces **2** sont conçues pour rayonner dans le domaine de l'infrarouge) fixés sur le corps **35** en étant superposés pour former une paroi **32** émettrice. On rappelle que par "série d'émetteurs", il faut entendre ici "au moins deux émetteurs".

Plus précisément, le corps **35**, qui se présente sous forme d'un bloc métallique de forme sensiblement prismatique, comprend une face **36** avant du côté de laquelle sont fixés les émetteurs **1**, et une face arrière opposée. Du côté de sa face **36** avant, le corps **35** est creusé pour former une chambre **37** en creux destinée à accueillir la paroi **32** émettrice, cette chambre **37** étant délimitée latéralement par une bordure **38** en saillie, à contour rectangulaire (aux coins de préférence arrondis, comme cela est illustré sur la figure 6).

Les émetteurs **1** peuvent être fixés sur le corps **35** par vissage, encliquetage, agrafage, sertissage, rivetage, ou par tout autre moyen analogue. Quel que soit leur mode de fixation, les émetteurs **1** sont positionnés de telle sorte qu'E2 soit sensiblement égal à E1.

Le corps **35** est percé de deux rangées de trous **39** pour le passage des conducteurs **28** gainés, de façon à permettre le raccordement de chaque émetteur **1** au réseau électrique.

L'alimentation du module **33** de chauffe en fluide caloporteur et l'évacuation du fluide caloporteur peuvent être assurées au moyen de flexibles pourvus, à leurs extrémités respectives, de raccords **40** rapides qui viennent s'encliqueter sur le corps **35**.

Le module **33** de chauffe comprend également une fenêtre **41**, réalisée dans un matériau transparent au rayonnement infrarouge (par ex. en quartz), qui vient se monter devant les émetteurs **1** pour les protéger de la poussière et de la vapeur d'eau, susceptibles d'en altérer le bon fonctionnement. La fenêtre **41** est plaquée contre la bordure **38** avec interposition d'un joint **42** d'étanchéité. Le module **33** comprend en outre un cadre **43** réalisé dans un matériau métallique, qui vient maintenir la fenêtre **41** en position. Le cadre **43** est pourvu d'une ouverture **44** qui vient encadrer l'ensemble des puces **2** de la paroi **32** émettrice. Le cadre **43** est par exemple fixé sur le corps **35** au moyen de vis. Le cadre **43** présente une face **45** avant qui est avantageusement polie pour former un miroir capable de réfléchir le rayonnement infrarouge issu d'autres de modules **33** de chauffe.

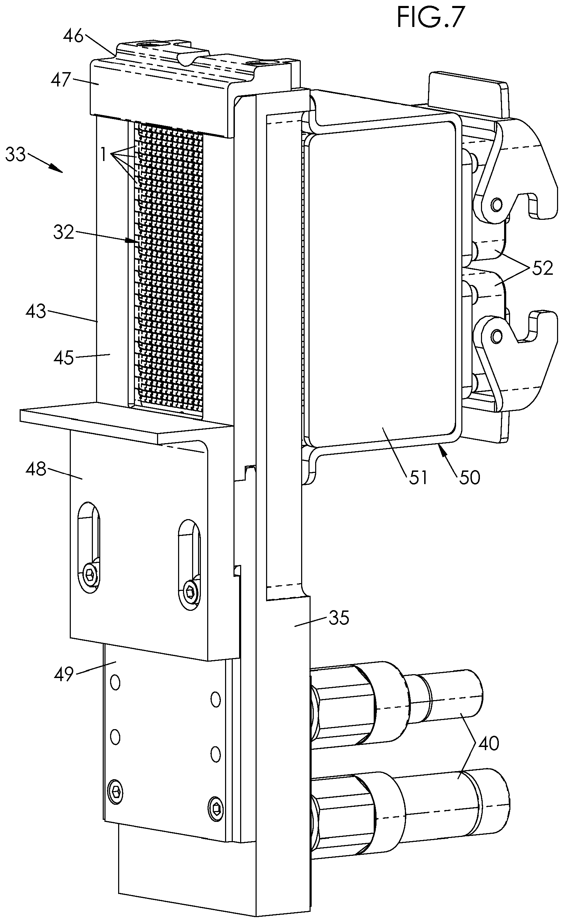

Selon un mode de réalisation illustré sur les figures 6 et 7, le module **33** de chauffe destiné à une application à la chauffe de préformes **8** peut en outre être équipé :

- d'un absorbeur **46** supérieur, en forme de cornière, qui vient coiffer le corps **35** en couvrant partiellement le cadre **43** et présente une face **47** avant dépolie ou pourvue d'un revêtement absorbant pour absorber le rayonnement infrarouge au droit du col des préformes **8** (le col ne doit pas être chauffé, car il présente sur chaque préforme **8** sa forme finale), et
- un réflecteur **48** inférieur, également en forme de cornière et qui vient se fixer sur le corps **35** pour réfléchir le rayonnement vers le fond des préformes **8**. Dans l'exemple illustré, le réflecteur **48** inférieur est monté sur le corps **35** par l'intermédiaire d'une platine **49** permettant de régler la position verticale du réflecteur **48** inférieur pour adapter le module **33** à différentes tailles de préformes **8**.

Le module **33** de chauffe peut en outre être équipé d'un boîtier **50** d'alimentation électrique, pourvu d'un carter **51** (partiellement arraché sur la figure 6) et de connecteurs **52** rapides montés à l'arrière du carter **51**. Le boîtier **50** d'alimentation abrite par exemple un répartiteur (non représenté pour des raisons de clarté) qui assure la distribution du courant électrique vers chacun des émetteurs **1**. Le raccordement électrique du répartiteur au réseau électrique externe se fait par exemple par des câbles (non représentés) munis de prises qui viennent se brancher sur les connecteurs **52**.

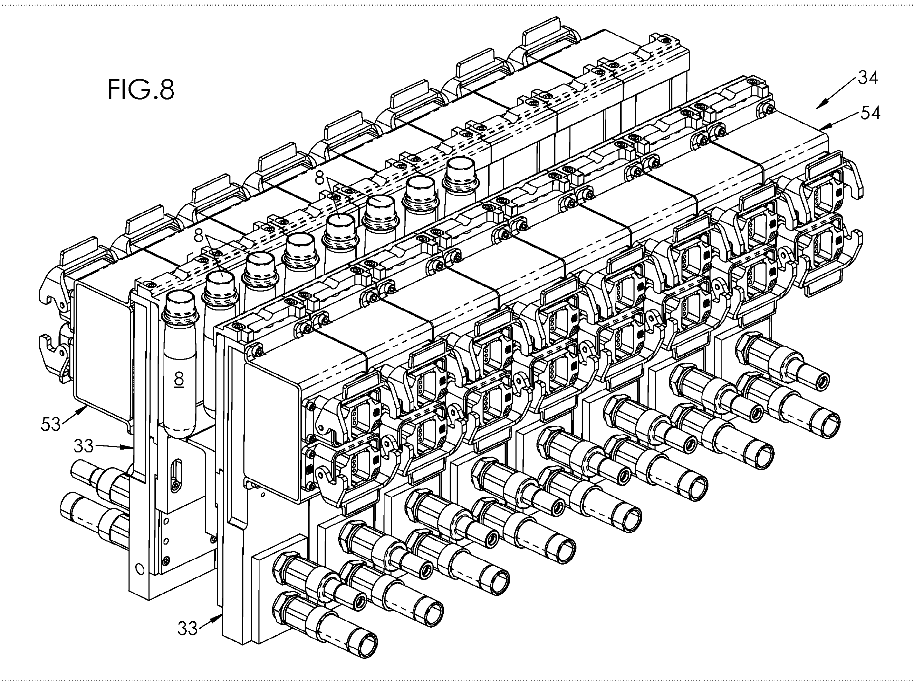

Il est possible, à l'aide d'une série de modules **33** de chauffe tels que celui qui vient d'être décrit, de construire une installation **34** de conditionnement thermique de préformes **8** en matière plastique, comme celle illustrée sur la figure 8.

Cette installation **34** comprend une série de modules **33** de chauffe juxtaposés (on rappelle ici que par "série de modules", il faut entendre ici "au moins deux modules") pour former une première paroi **53** rayonnante devant laquelle défilent les préformes **8**. Les réflecteurs **48** inférieurs des modules **33** de chauffe sont réglés en hauteur pour s'adapter au format des préformes **8**. Dans l'exemple illustré, l'installation **34** comprend une deuxième paroi **54** rayonnante également formée d'une série de modules **33** de chauffe juxtaposés, en regard de la première paroi **53**.

Le rayonnement issu de chaque paroi **53**, **54** est partiellement absorbé par les préformes, et partiellement réfléchi sur les modules **33** de chauffe placés en regard, ce qui augmente le rendement énergétique de l'installation **34**.

La répartition uniforme des rangées **9**, **10** de puces **2** au sein de chaque module **33** permet notamment d'obtenir un profil de chauffe homogène (lorsqu'un tel profil est requis). Il est également plus facile d'obtenir un profil de chauffe non homogène (lorsqu'un tel profil est souhaité), notamment pour chauffer certaines zones des préformes **8** plus que d'autres.

**Revendications**

1.  Module (33) pour la chauffe de préformes, comprenant un corps (35) et une série d'émetteurs (1) laser, chacun des émetteurs (1) laser étant fixé au corps (35) en étant superposés et comprenant:

    - un support (3) présentant une face (4) frontale et délimité, de part et d'autre de sa face (4) frontale, par une face latérale (6) supérieure et une face (7) latérale inférieure opposées ;
    - des puces (2) laser montées sur la face (4) frontale du support (3), une partie ou la totalité des les puces (2) laser sont conçues pour émettre dans le domaine infrarouge
    - au moins une alimentation (15) en courant électrique des puces (2) laser; en outre pour au moins deux émetteurs (1) laser fixés au corps en étant superposés :
- les puces (2) laser sont arrangées en au moins deux rangées (9, 10) de puces laser, y compris :

   o une rangée (9) supérieure ayant un bord (11) externe tourné vers la face (6) latérale supérieure du support (3) et un bord (12) interne opposé,
   o une rangée (10) inférieure ayant un bord (13) externe tourné vers la face (7) latérale inférieure du support (3) et un bord (14) interne opposé ;

chaque rangée de puces étant reliée à une alimentation en courant électrique dédiée munie d'une paire de bornes électriques (16, 17) de signes opposés, et
- la distance E1 entre les bords (12, 14) internes de deux rangées (9, 10) parallèles et adjacentes de puces (2) est supérieure ou égale à la somme de la distance E3 du bord (11) externe de la rangée (9) supérieure à la face (6) latérale supérieure et de la distance E4 du bord (13) externe de la rangée (10) inférieure à la face (7) latérale inférieure.

2. Module (33) selon la revendication 1, **caractérisé en ce que** la distance E2 entre

   - la rangée (9) supérieure d'un émetteur (1) et
   - la rangée (10) inférieure d'un émetteur (1) voisin pris parmi lesdits au moins deux émetteurs, est sensiblement égale à E1.

3. Module (33) selon la revendication 1 ou 2, **caractérisé en ce que** chaque puce (2) laser est composée d'une ou de plusieurs cavités LASER à émission de surface.

4. Module (33) l'une des revendications 1 à 3, **caractérisé en ce que** chaque rangée (9, 10) comprend deux brins (18, 19) parallèles de puces (2), à savoir un brin (18) externe relié à une borne (16) électrique, et un brin (19) interne relié, par une extrémité, au brin (18) externe et, par une extrémité opposée, à la borne (17) électrique de signe opposé.

5. Module (33) selon l'une des revendications précédentes, **caractérisé en ce que** la distance E1 est comprise entre 0,2 mm et 1 mm.

6. Module (33) selon la revendication 5, **caractérisé en ce que** la distance E3 et la distance E4 sont toutes deux comprises entre 0,1 mm et 0,5 mm.

7. Module (33) selon l'une des revendications précédentes, **caractérisé en ce que** les distances E3 et E4 sont égales.

8. Module (33) pour la chauffe de préformes, comprenant un corps (35) et une série d'émetteurs (1) laser, chacun des émetteurs (1) laser étant fixé au corps (35) en étant superposés et comprenant:

   - un support (3) présentant une face (4) frontale et délimité, de part et d'autre de sa face (4) frontale, par une face latérale (6) supérieure et une face (7) latérale inférieure opposées ;
   - des puces (2) laser montées sur la face (4) frontale du support (3), une partie ou la totalité des les puces (2) laser sont conçues pour émettre dans le domaine infrarouge
   - au moins une alimentation (15) en courant électrique des puces (2) laser; en outre, pour au moins un premier émetteur (1) laser et pour un deuxième émetteur laser superposé au premier émetteur laser :
   - les puces (2) laser sont arrangées en au moins deux rangées (9, 10) de puces laser, y compris :

      o une rangée (9) supérieure ayant un bord (11) externe tourné vers la face (6) latérale supérieure du support (3) et un bord (12) interne opposé,
      o une rangée (10) inférieure ayant un bord (13) externe tourné vers la face (7) latérale inférieure du support (3) et un bord (14) interne opposé ;

   chaque rangée (9, 10) de puces (2) étant reliée à une alimentation (15) en courant électrique dédiée munie d'une paire de bornes (16, 17) électriques de signes opposés, et
   - la distance E2 entre la rangée (9) supérieure du premier émetteur (1) laser et la rangée (10) inférieure du deuxième émetteur (1) laser est sensiblement égale à la distance E1 entre les bords internes de deux rangées parallèles et adjacentes de puces des premier et deuxième émetteurs laser.

9. Module (33) selon la revendication 8, **caractérisé en ce que** chaque puce (**2**) laser est une puce VCSEL et/ou est conçue pour émettre dans le domaine infrarouge.

10. Module (33) selon la revendication 8 ou la revendication 9, **caractérisé en ce que** chaque rangée (**9**, **10**) comprend deux brins (**18**, **19**) parallèles de puces (**2**), à savoir un brin (**18**) externe relié à une borne (**16**) électrique, et un brin (**19**) interne relié, par une extrémité, au brin (**18**) externe et, par une extrémité opposée, à la borne (**17**) électrique de signe opposé.

11. Module (33) selon l'une des revendications 8 à 10 **caractérisé en ce que** la distance E1 entre les bords (12, 14) internes de deux rangées (9, 10) parallèles et adjacentes de puces (2) est supérieure ou égale à la somme de la distance E3 du bord (11) externe de la rangée (9) supérieure à la face (6) latérale supérieure et de la distance E4 du bord (13) externe de la rangée (10) inférieure à la face (7) latérale inférieure.

12. Installation (34) de chauffe de préformes (8) en matière plastique, comprenant au moins une série de modules (33) selon l'une de revendications précédentes, qui sont juxtaposés.


**Patentansprüche**

1. Modul (33) zum Erhitzen von Vorformen, beinhaltend einen Körper (35) und eine Serie von Laseremittern (1), wobei jeder der Laseremitter (1) übereinander angeordnet an dem Körper (35) befestigt ist und Folgendes beinhaltet:

   - einen Träger (3), der eine Stirnfläche (4) aufweist und auf beiden Seiten seiner Stirnfläche (4) durch eine obere Seitenfläche (6) und eine entgegengesetzte untere Seitenfläche (7) begrenzt wird;
   - Laserchips (2), die an der Stirnfläche (4) des Trägers (3) angebracht sind, wobei ein Teil oder alle der Laserchips (2) dazu ausgelegt sind, im Infrarotbereich zu emittieren,
   - mindestens eine elektrische Stromversorgung (15) der Laserchips (2);
   wobei ferner bei mindestens zwei Laseremittern (1), die übereinander angeordnet an dem Körper befestigt sind:
   - die Laserchips (2) in mindestens zwei Reihen (9, 10) von Laserchips eingerichtet sind, darin enthalten:

      o eine obere Reihe (9), die eine Außenkante (11), die der oberen Seitenfläche (6) des Trägers (3) zugewandt ist, und eine entgegengesetzte Innenkante (12) aufweist,
      o eine untere Reihe (10), die eine Außenkante (13), die der unteren Seitenfläche (7) des Trägers (3) zugewandt ist, und eine entgegengesetzte Innenkante (14) aufweist;

   wobei jede Reihe von Chips mit einer dedizierten elektrischen Stromversorgung verbunden ist, die mit einem Paar elektrischer Anschlüsse (16, 17) mit entgegengesetzten Vorzeichen versehen ist, und
   - der Abstand E1 zwischen den Innenkanten (12, 14) von zwei parallelen und benachbarten Reihen (9, 10) von Chips (2) größer als oder gleich der Summe aus dem Abstand E3 der Außenkante (11) der oberen Reihe (9) zu der oberen Seitenfläche (6) und dem Abstand E4 der Außenkante (13) der unteren Reihe (10) zu der unteren Seitenfläche (7) ist.

2. Modul (33) nach Anspruch 1, **dadurch gekennzeichnet, dass** der Abstand E2 zwischen

   - der oberen Reihe (9) eines Emitters (1) und
   - der unteren Reihe (10) eines benachbarten Emitters (1) von den mindestens zwei Emittern im Wesentlichen gleich E1 ist.

3. Modul (33) nach Anspruch 1 oder 2, **dadurch gekennzeichnet, dass** jeder Laserchip (2) aus einem oder mehreren oberflächenemittierenden Laserresonatoren besteht.

4. Modul (33) nach einem der Ansprüche 1 bis 3, **dadurch gekennzeichnet, dass** jede Reihe (9, 10) zwei parallele Stränge (18, 19) von Chips (2) beinhaltet, nämlich einen äußeren Strang (18), der mit einem elektrischen Anschluss (16) verbunden ist, und einen inneren Strang (19), der an einem Ende mit dem äußeren Strang (18) und an einem entgegengesetzten Ende mit dem elektrischen Anschluss (17) mit entgegengesetztem Vorzeichen verbunden ist.

5. Modul (33) nach einem der vorhergehenden Ansprüche, **dadurch gekennzeichnet, dass** der Abstand E1 zwischen 0,2 mm und 1 mm liegt.

6. Modul (33) nach Anspruch 5, **dadurch gekennzeichnet, dass** der Abstand E3 und der Abstand E4 beide zwischen 0,1 mm und 0,5 mm liegen.

7. Modul (33) nach einem der vorhergehenden Ansprüche, **dadurch gekennzeichnet, dass** die Abstände E3 und E4 gleich sind.

8. Modul (33) zum Erhitzen von Vorformen, beinhaltend einen Körper (35) und eine Serie von Laseremittern (1), wobei jeder der Laseremitter (1) übereinander angeordnet an dem Körper (35) befestigt ist und Folgendes beinhaltet:

   - einen Träger (3), der eine Stirnfläche (4) aufweist und auf beiden Seiten seiner Stirnfläche (4) durch eine obere Seitenfläche (6) und eine entgegengesetzte untere Seitenfläche (7) begrenzt wird;
   - Laserchips (2), die an der Stirnfläche (4) des Trägers (3) angebracht sind, wobei ein Teil oder alle der Laserchips (2) dazu ausgelegt sind, im Infrarotbereich zu emittieren,
   - mindestens eine elektrische Stromversorgung (15) der Laserchips (2);

wobei ferner für mindestens einen ersten Laseremitter (1) und für einen über dem ersten Laseremitter liegenden zweiten Laseremitter:
- die Laserchips (2) in mindestens zwei Reihen (9, 10) von Laserchips angeordnet sind, darin enthalten:

    o eine obere Reihe (9), die eine Außenkante (11), die der oberen Seitenfläche (6) des Trägers (3) zugewandt ist, und eine entgegengesetzte Innenkante (12) aufweist,
    o eine untere Reihe (10), die eine Außenkante (13), die der unteren Seitenfläche (7) des Trägers (3) zugewandt ist, und eine entgegengesetzte Innenkante (14) aufweist;

wobei jede Reihe (9, 10) von Chips (2) mit einer dedizierten elektrischen Stromversorgung (15) verbunden ist, die mit einem Paar elektrischer Anschlüsse (16, 17) mit entgegengesetzten Vorzeichen versehen ist, und
- der Abstand E2 zwischen der oberen Reihe (9) des ersten Laseremitters (1) und der unteren Reihe (10) des zweiten Laseremitters (1) im Wesentlichen gleich dem Abstand E1 zwischen den Innenkanten von zwei parallelen und benachbarten Reihen von Chips des ersten und zweiten Laseremitters ist.

9. Modul (33) nach Anspruch 8, **dadurch gekennzeichnet, dass** jeder Laserchip (**2**) ein VCSEL-Chip ist und/oder dazu ausgelegt ist, im Infrarotbereich zu emittieren.

10. Modul (33) nach Anspruch 8 oder 9, **dadurch gekennzeichnet, dass** jede Reihe (**9**, **10**) zwei parallele Stränge (**18**, **19**) von Chips (**2**) beinhaltet, nämlich einen äußeren Strang (**18**), der mit einem elektrischen Anschluss (**16**) verbunden ist, und einen inneren Strang (**19**), der an einem Ende mit dem äußeren Strang (**18**) und an einem entgegengesetzten Ende mit dem elektrischen Anschluss (**17**) mit entgegengesetztem Vorzeichen verbunden ist.

11. Modul (33) nach einem der Ansprüche 8 bis 10, **dadurch gekennzeichnet, dass** der Abstand E1 zwischen den Innenkanten (12, 14) von zwei parallelen und benachbarten Reihen (9, 10) von Chips (2) größer als oder gleich der Summe aus dem Abstand E3 der Außenkante (11) der oberen Reihe (9) zu der oberen Seitenfläche (6) und dem Abstand E4 der Außenkante (13) der unteren Reihe (10) zu der unteren Seitenfläche (7) ist.

12. Anlage (34) zum Erhitzen von Vorformen (8) aus Kunststoff, beinhaltend mindestens eine Serie von Modulen (33) nach einem der vorhergehenden Ansprüche, die nebeneinanderliegen.

**Claims**

1. Module (33) for heating preforms, comprising a body (35) and a series of laser emitters (1), each one of the laser emitters (1) being secured to the body (35) in a superposed manner and comprising:

    - a support (3) that has a front face (4) and is delimited, on either side of its front face (4), by an upper lateral face (6) and a lower lateral face (7) that are opposite one another;
    - laser chips (2) that are mounted on the front face (4) of the support (3), some or all of the laser chips (2) being designed to emit in the infrared range;
    - at least one power supply (15) for supplying electric current to the laser chips (2);
    furthermore, for at least two laser emitters (1) secured to the body in a superposed manner:
    - the laser chips (2) are arranged in at least two rows (9, 10) of laser chips, including:

       o an upper row (9) that has an outer edge (11) facing toward the upper lateral face (6) of the support (3) and an opposite inner edge (12),
       o a lower row (10) that has an outer edge (13) facing toward the lower lateral face (7) of the support (3) and an opposite inner edge (14);

    each row of chips being connected to a dedicated power supply for supplying electric current, which is provided with a pair of electrical terminals (16, 17) with opposite signs, and
    - the distance E1 between the inner edges (12, 14) of two parallel and adjacent rows (9, 10) of chips (2) is greater than or equal to the sum of the distance E3 from the outer edge (11) of the upper row (9) to the upper lateral face (6) and the distance E4 from the outer edge (13) of the lower row (10) to the lower lateral face (7).

2. Module (33) according to Claim 1, **characterized in that** the distance E2 between

    - the upper row (9) of an emitter (1) and
    - the lower row (10) of a neighbouring emitter (1) taken from among said at least two emitters is substantially equal to E1.

3. Module (33) according to Claim 1 or 2, **characterized in that** each laser chip (2) is made up of one or more surface-emitting laser cavities.

**4.** Module (33) according to one of Claims 1 to 3, **characterized in that** each row (9, 10) comprises two parallel strands (18, 19) of chips (2), namely an outer strand (18) connected to an electrical terminal (16) and an inner strand (19), one end of which is connected to the outer strand (18) and the other end of which is connected to the electrical terminal (17) with the opposite sign.

**5.** Module (33) according to one of the preceding claims, **characterized in that** the distance E1 is between 0.2 mm and 1 mm.

**6.** Module (33) according to Claim 5, **characterized in that** the distance E3 and the distance E4 are both between 0.1 mm and 0.5 mm.

**7.** Module (33) according to one of the preceding claims, **characterized in that** the distances E3 and E4 are equal.

**8.** Module (33) for heating preforms, comprising a body (35) and a series of laser emitters (1), each one of the laser emitters (1) being secured to the body (35) in a superposed manner and comprising:

- a support (3) that has a front face (4) and is delimited, on either side of its front face (4), by an upper lateral face (6) and a lower lateral face (7) that are opposite one another;
- laser chips (2) that are mounted on the front face (4) of the support (3), some or all of the laser chips (2) being designed to emit in the infrared range;
- at least one power supply (15) for supplying electric current to the laser chips (2);
furthermore, for at least a first laser emitter (1) and for a second laser emitter superposed on the first laser emitter:
- the laser chips (2) are arranged in at least two rows (9, 10) of laser chips, including:

o an upper row (9) that has an outer edge (11) facing toward the upper lateral face (6) of the support (3) and an opposite inner edge (12),
o a lower row (10) that has an outer edge (13) facing toward the lower lateral face (7) of the support (3) and an opposite inner edge (14);

each row (9, 10) of chips (2) being connected to a dedicated power supply (15) for supplying electric current, which is provided with a pair of electrical terminals (16, 17) with opposite signs, and
- the distance E2 between the upper row (9) of the first laser emitter (1) and the lower row (10) of the second laser emitter (1) is substantially equal to the distance E1 between the inner edges of two parallel and adjacent rows of chips of the first and second laser emitters.

**9.** Module (33) according to Claim 8, **characterized in that** each laser chip (2) is a VCSEL chip and/or is designed to emit in the infrared range.

**10.** Module (33) according to Claim 8 or 9, **characterized in that** each row (9, 10) comprises two parallel strands (18, 19) of chips (2), namely an outer strand (18) connected to an electrical terminal (16) and an inner strand (19), one end of which is connected to the outer strand (18) and the other end of which is connected to the electrical terminal (17) with the opposite sign.

**11.** Module (33) according to one of Claims 8 to 10, **characterized in that** the distance E1 between the inner edges (12, 14) of two parallel and adjacent rows (9, 10) of chips (2) is greater than or equal to the sum of the distance E3 from the outer edge (11) of the upper row (9) to the upper lateral face (6) and the distance E4 from the outer edge (13) of the lower row (10) to the lower lateral face (7).

**12.** Installation (34) for heating plastic preforms (8), comprising at least one series of modules (33) according to one of the preceding claims, which are arranged next to one another.

FIG.1

EP 3 488 508 B1

FIG.2

FIG.3

FIG.4

FIG.5

FIG.6

FIG.7

FIG.8

EP 3 488 508 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2982790
- US 20140305919 A
- US 8783893 B
- DE 102005061334